# EUROPÄISCHE PATENTSCHRIFT

(11) **EP 4 661 631 B1**
(45) Veröffentlichungstag und Bekanntmachung des Hinweises auf die Patenterteilung: **16.09.2026**
(21) Anmeldenummer: 25180520.6
(22) Anmeldetag: 03.06.2025
(51) Int. Cl.: H10F 71/00

(54) **VERFAHREN ZUR HERSTELLUNG VON EINER DURCHGANGSÖFFNUNG BEI EINER GERMANIUM HALBLEITERSCHEIBE MIT AUFLIEGENDEN III-V HALBLEITERSCHICHTEN**
METHOD FOR FORMING A VIA HOLE IN A GERMANIUM SEMICONDUCTOR WAFER WITH OVERLYING III-V SEMICONDUCTOR LAYERS
PROCÉDÉ DE FABRICATION D'UNE OUVERTURE TRAVERSANTE DANS UNE PLAQUETTE SEMI-CONDUCTRICE EN GERMANIUM AYANT DES COUCHES SEMI-CONDUCTRICES III-V À SA SURFACE

(30) Priorität: 07.06.2024 DE 102024001861
(43) Veröffentlichungstag der Anmeldung: 10.12.2025
(73) Patentinhaber: Azur Space Solar Power GmbH, 74072 Heilbronn (DE)
(72) Erfinder: Köstler, Wolfgang, 74074 Heilbronn (DE); Hagedorn, Benjamin, 74360 Ilsfeld (DE)
(74) Vertreter: Koch Müller Patentanwaltsgesellschaft mbH

(56) Entgegenhaltungen:
- US-A1- 2021 066 519
- US-B2- 11 063 170

## Beschreibung

Eine Durchgangsöffnung bildet einen elektrischen Anschluss von einer Oberfläche der Halbleiterscheibe mit aufliegenden III-V Halbleiterschichten zu einer Rückseite der Halbleiterscheibe aus. Hierdurch lässt sich die Oberfläche von der Rückseite her elektrisch kontaktieren. Anders ausgedrückt, es wird ein rückseitiger Oberflächenanschluss ausgebildet.

Aus der DE 10 2019 006 094 A1 ist ein Verfahren zur Herstellung einer Durchgangsöffnung bei einer Germanium Halbleiterscheibe mit aufliegenden III-V Schichten bekannt, wobei für die Herstellung der Durchgangsöffnung verschiedene Prozessschritte ausgeführt werden. Unter anderem wird auf der Oberseite der Halbleiterscheibe in einem zweiten Lackprozess eine zweite Öffnung in der zweiten Lackschicht erzeugt, wobei die zweite Öffnung größer ist als die an der Oberseite bereits bestehende Öffnung und die zweite Öffnung die bestehende Öffnung umschließt.

Vor diesem Hintergrund besteht die Aufgabe der Erfindung darin, eine Vorrichtung anzugeben, die den Stand der Technik weiterbildet.

Die Aufgabe wird durch ein Verfahren zur Herstellung einer Durchgangsöffnung bei einer Germanium Halbleiterscheibe mit aufliegenden III-V Schichten mit den Merkmalen des Patentanspruchs 1 gelöst. Vorteilhafte Ausgestaltungen der Erfindung sind Gegenstand von Unteransprüchen.

Mit dem Verfahren wird eine Durchgangsöffnung bei einer Germanium Halbleiterscheibe mit aufliegenden III-V Schichten erzeugt.

Die Germanium Halbleiterscheibe weist einen Durchmesser von wenigstens 100 mm und eine Dicke oberhalb von 80 µm auf.

Des Weiteren weist die Germanium-Halbleiterscheibe eine Rückseite und eine Vorderseite auf und ist als Substrat ausgebildet.

Auf der Vorderseite der Germanium-Scheibe sind mehrere III-V Schichten ausgebildet, wobei ein Teil der III-V Schichten eine Oberfläche der Halbleiterscheibe ausbilden.

In einem Verfahrensschritt wird in einem ersten Photolithographieprozess auf der Oberfläche ein erster Lack strukturiert, wobei bei der Strukturierung erste lackfreie Bereiche für die Ausbildung der Durchgangsöffnung ausgebildet werden.

Alternativ wird mittels eines ersten Druckprozesses der erste Lack strukturiert aufgebracht, um die ersten lackfreien Bereiche auszubilden.

Ein Vorteil des ersten Druckprozesses in einem Vergleich mit dem ersten Photolithographieprozess ist unter anderem, dass eine aufwändige Belichtung und Entwicklung des ersten Lackes entfällt. Anders ausgedrückt, der erste Lack wird bei dem ersten Druckprozess nur in den zu belackenden Bereichen aufgebracht, d.h. der erste Lack wird nicht in den Bereichen für die Ausbildung der Durchgangsöffnung aufgebracht.

In einem nachfolgenden Prozessschritt werden die auf der Vorderseite der Germanium-Halbleiterscheibe aufliegenden III-V Schichten in den ersten lackfreien Bereichen nasschemisch entfernt, um eine ovale lochartige Vertiefung mit umlaufenden Seitenflächen und einem Bodenbereich aus der Vorderseite der Germanium-Halbleiterscheibe auszubilden.

Es sei angemerkt, dass unter dem Begriff "oval" sowohl kreisförmige, insbesondere auch kreisrunde Formen als Spezialfälle als auch längliche, ellipsenförmige Strukturen verstanden werden.

Es versteht sich, dass nach dem Ätzen der erste Lack vollständig entfernt wird. In einer Weiterbildung wird das Entfernen des Lacks mittels eines Plasmaveraschungsschritt und einem anschließenden Reinigungsschritt durchgeführt.

In einem weiteren Verfahrensschritt wird nach dem Entfernen des ersten Lacks mittels eines zweiten Photolithographieprozesses ein zweiter Lack aufgebracht und in dem Bodenbereich der Vertiefung strukturiert, um zweite lackfreie Bereiche in dem Bodenbereich auszubilden. Es versteht sich hierbei, dass nach einem Belackungsprozess als Teil des zweiten Photolithographieprozesses der zweite Lack auf der Oberseite der III-V Schichten in dem Bereich der Öffnung über den Rand der Öffnung hinweg auch die Seitenflächen und den Bodenbereich der Öffnung vollständig bedeckt und erst nach der Strukturierung innerhalb des Photolithographieprozesses die lackfreien Bereiche in dem Bodenbereich sich ausbilden.

Alternativ zu dem zweiten Photolithographieprozess wird mittels eines zweiten Druckprozesses der zweite Lack bereits strukturiert aufgebracht, um die zweiten lackfreien Bereiche in dem Bodenbereich auszubilden.

Ein Vorteil des zweiten Druckprozesses, entsprechend den Vorteilen des ersten Druckprozesses ist, dass eine aufwändige Belichtung und Entwicklung des zweiten Lackes entfällt. Anders ausgedrückt, der zweite Lack wird bei dem zweiten Druckprozess nur in den zu belackenden Bereichen aufgebracht.

Es versteht sich dabei, dass der zweite Lack auch auf die Seitenflächen aufgebracht wird, d.h. die umlaufenden Seitenflächen der Vertiefung werden vollständig von dem zweiten Lack abgedeckt, um die Seitenflächen vor einem Ätzangriff zu schützen. Anders ausgedrückt, bei dem Druckprozess werden wenigstens zusätzlich zu dem um die Öffnung umlaufenden Randbereich auf der Oberfläche der III-V-Schichten sowie den Seitenflächen, eine umlaufender Randbereich auf dem Boden mit dem zweiten Lack bedeckt, sodass ein zweite Lackfreier Bereich in Bodenbereich ausgebildet wird.

Auch sei angemerkt, dass die zweiten lackfreien Bereiche in einem zentralen Bereich des Bodens der Vertiefung ausgebildet werden. Anders ausgedrückt, in dem Bodenbereich ist ein vollständig umlaufender in Zusammenhang mit der Seitenfläche stehender randförmiger Bereich mit dem zweiten Lack bedeckt.

In einem weiteren Verfahrensschritt wird in den zweiten lackfreien Bereichen des Bodenbereichs mittels eines Laserprozesses in der Germaniumschicht ein von dem Bodenbereich der Vertiefung bis zu der Rückseite der Halbleiterscheibe reichendes Durchgangsloch erzeugt. Hierbei wird der Laser nur in den zweiten lackfreien Bereichen angewendet und in dem Bodenbereich eine in Zusammenhang mit der Seitenfläche stehende umlaufender stufenförmigen Absatz bzw. eine erste Stufe ausgebildet.

Es versteht sich hierbei, dass die erste Stufe in dem Bodenbereich der Vertiefung entlang zu den jeweiligen Seitenflächen verlaufen und die Stufenfläche der ersten Stufe aus Germanium besteht.

Auch sei angemerkt, dass vorliegend der Begriff maximale Breite bei der Vertiefung als auch bei dem Durchgangsloch, im Falle einer kreisrunden Ausführung immer der Durchmesser der Form bezeichnet. Im Fall von anderen Ausführungsformen, d. h. Ausführungsformen die nicht kreisrund sind, der Begriff "maximale Breite" jeweils die maximale Entfernung von zwei sich einander, entlang einer parallel zu der Oberfläche verlaufenden Geraden, gegenüberliegenden Seitenflächenabschnitten bezeichnet.

Entsprechend bezeichnet der Begriff "minimale Breite" die geringste Entfernung im Falle einer kreisrunden Ausführung immer den Durchmesser der Form, während bei den anderen nichtkreisrunden Ausführungen der Begriff jeweils die minimale Entfernung von zwei sich einander, entlang einer parallel zu der Oberfläche verlaufenden Geraden, gegenüberliegenden Seitenflächenabschnitten bezeichnet.

Es versteht sich daher, dass bei einer kreisrunden Ausführung die maximale Breite und die minimale Breite genau gleich groß sind und jeweils genau den Durchmesser bezeichnen.

Auch sei angemerkt, dass mit dem Begriff, die Ausdehnung der Vertiefung oder die Ausdehnung des Durchgangslochs, die sich jeweils aus der minimalen Breite und der maximalen Breite ergebenden Größe der Öffnung bezeichnet wird.

Es versteht sich, dass die Durchgangsöffnung aus der Vertiefung mit der ersten Breite und aus der erste umlaufenden Stufe in dem Bodenbereich der Vertiefung und dem Durchgangsloch mit einer zweiten umlaufenden Stufe, ausschließlich im Germanium ausgebildet, an dem oberen Rand des Loches in besteht, wobei die zweite Breite des Durchgangslochs kleiner als die erste Breite ist. Es versteht sich, dass die zweite Breite zumindest um die Tiefe der Stufenfläche kleiner ist als die erste Breite.

Des Weiteren sei angemerkt, dass die Vertiefung an der Oberfläche beginnt und an der Oberfläche eine obere Kante zur zweiten Stufe aufweist. An dem Ende der Vertiefung d.h. an einem Übergang der Seitenfläche zu der Bodenfläche weist die Vertiefung eine untere Kante auf. Hierbei bezeichnet die erste Breite die Größe der Öffnung an der oberen Kante der Vertiefung, während die Größe der Vertiefung an der unteren Kante eine dritte Breite aufweist.

Sind die Seitenflächen der Vertiefung senkrecht oder in einer ersten Näherung senkrecht, ist die dritte Breite gleich groß wie die erste Breite oder etwas kleiner.

In einer Weiterbildung ist die dritte Breite wenigstens um 0,1 µm und maximal um 2 µm kleiner.

Auch sei angemerkt, dass das Durchgangsloch in dem Bodenbereich, d.h. an der Vorderseite der Germaniumschicht beginnt und an der Vorderseite eine erste Kante aufweist.

An dem Ende des Durchgangslochs d.h. an einem Übergang der Seitenfläche des Durchgangslochs zu der Rückseite der Germaniumschicht weist das Durchgangsloch eine zweite Kante auf. Hierbei bezeichnet die zweite Breite die Größe der Öffnung an der oberen Kante des Durchgangslochs, während die Größe des Durchgangslochs an der unteren Kante eine vierte Breite aufweist.

Sind die Seitenflächen des Durchgangslochs senkrecht ausgebildet, ist die vierte Breite gleich groß wie die zweite Breite.

In einer Weiterbildung ist das Durchgangsloch entlang der Tiefenerstreckung konisch ausgebildet, d.h. die vierte Breite ist kleiner als die zweite Breite.

In einer Ausführungsform ist die vierte Breite um wenigstens 0,5 µm und höchstens um 10 µm kleiner.

Es versteht sich, dass bei einer kreisförmigen Ausbildung als Spezialfall der allgemeinen ovalen Ausführungsform, die jeweilige Breite jeweils den Durchmesser des Kreises bezeichnet.

Des Weiteren sei angemerkt, dass vorliegend die Begriffe Germanium Halbleiterscheibe und Halbleiterscheibe synonym verwendet werden.

In einer Weiterbildung werden mittels des Lasers ovale Durchgangslöcher erzeugt.

In einer anderen Weiterbildung sind die Durchgangslöcher kreisförmig ausgebildet.

Es versteht sich, dass die zweiten lackfreien Bereiche in einem zentralen Bereich des Bodens ausgebildet werden und nach dem Ausbilden des Durchganglochs sich eine umlaufende Stufenkante der ersten Stufe ausbildet.

In einem nachfolgenden zweiten Nassätzschritt wird das Durchgangsloch überätzt und ein Teil der Germaniumschicht entfernt. Hierbei bildet sich die zweite Stufe mit einer weiteren Stufenkante aus.

In einem weiteren Schritt wird der zweite Lack vollständig entfernt, um die Durchgangsöffnung auszubilden, wobei bei der Durchgangsöffnung die Breite der Vertiefung größer ist als die Breite des Durchgangslochs.

Es sei angemerkt, dass bei dem ersten Nassätzschritt und bei dem zweiten Nassätzschritt unterschiedliche Ätzlösungen bzw. unterschiedliche Säuren verwendet werden. Nachfolgend werden die beiden Begriffe "Ätzlösung" und "Säure" synonym verwendet.

Insbesondere weist die in dem ersten Nassätzschritt verwendete Säure eine andere Zusammensetzung als die Ätzlösung in dem zweiten Nassätzschritt auf.

Des Weiteren sei angemerkt, dass bei der Durchführung des ersten Nassätzschrittes die Säure gegenüber Germanium eine geringere Ätzrate als gegenüber von den III-V Schichten aufweist.

Ein Vorteil ist hierbei, dass die Zeitdauer der Nassätzung nicht sensitiv gegenüber einer Ätzung der Germanium Schicht ist und sich hierdurch in dem Bodenbereich der Vertiefung die III-V Schichten zuverlässig und insbesondere vollständig entfernen lassen.

In einer Ausführungsform weist die Säure in dem ersten Nassätzschritt keine oder eine sehr geringe Ätzrate gegenüber Germanium auf. Hierdurch lässt sich in dem Bodenbereich der Vertiefung die Vorderseite der Germanium-Halbleiterscheibe besonderes einfach und zuverlässig freilegen.

Es versteht sich, dass mit dem Begriff "III-V Schichten" eine Abfolge von Schichten aus jeweils einer III-V Verbindung bezeichnet ist, wobei mindestens zwei unmittelbar aufeinanderfolgenden Schichten eine unterschiedliche Stöchiometrie und / oder eine unterschiedliche Materialzusammensetzung aufweisen.

In einer Ausführungsform umfassen die III-V Schichten eine oder mehrere Solarzellen. Bei mehreren Solarzellen sind zwischen zwei und sieben oder zwischen drei und fünf Teilsolarzellen aufeinandergestapelt und mittels dazwischenliegenden Tunneldioden in Serie verschaltet.

In einer anderen Ausführungsform ist an der Vorderseite bzw. in der Vorderseite der Germanium-Schicht ein n/p Übergang d.h. eine Solarzelle ausgebildet.

Es versteht sich, dass sich mit dem vorliegenden Verfahren auch eine Vielzahl von Durchgangsöffnungen auf der Oberfläche herstellen lassen.

Insbesondere bei einer Verwendung des Verfahrens bei einer Mehrfachsolarzelle lässt sich mit einer Vielzahl von Durchgangsöffnungen ein niederohmiger elektrischer Kontakt der Oberfläche hin zu der Rückseite ausbilden, indem sich die elektrischen Kontakte nicht nur an dem Rand, sondern auch in der Mitte der Solarzelle oder an beliebigen Stellen der Oberfläche anordnen lassen. Gerade bei großen Solarzellenflächen lassen sich hierdurch die ohmschen Verluste auf der Oberfläche bei hohen Strömen reduzieren.

Ein weiterer Vorteil des Verfahrens ist es, das sich auf einfache und besonders kostengünstige Weise auf der Oberfläche der Halbleiterscheibe eine oder mehrere Durchgangsöffnungen, insbesondere für eine Ausbildung von elektrischen Durchkontaktierungen zuverlässig und kostengünstig erzeugen lassen.

Ein anderer Vorteil ist, dass sich mittels der rückseitigen Kontaktierung die Größe von Metallflächen auf der Vorderseite reduzieren lassen. Hiermit lässt sich die Größe der Empfangsfläche bei einer Ausbildung von einer oder mehreren Solarzellen auf der Vorderseite erhöhen.

Insbesondere erübrigen sich durch den Einsatz von Nassätzprozessen teure und aufwendige Trockenätzprozesse.

Ein anderer Vorteil ist, dass durch die Ausführung des zweiten Nassätzschrittes nach der Ausbildung des Durchgangsloches mittels eines Laserprozessschrittes, eventuelle vorhandene Ablagerungen durch das Verdampfen von Germanium auf den Bereichen mit dem zweiten Lack einfach und schnell entfernen lassen.

Des Weiteren wird das Durchgangsloch durch den zweiten Nassätzschritt überätzt und von Resten des Laserprozesses gereinigt. Anders ausgedrückt, der zweite Nassätzschritt entfernt die von dem Laserprozess verursachten Verunreinigungen sowohl an der Oberfläche auch an der Unterseite als auch in dem Durchgangsloch zuverlässig, schnell und kostengünstig.

Überraschender Weise hat sich gezeigt, dass mittels des ersten Nassätzschrittes bei der Ausbildung der ovalen Vertiefung steile Seitenflächen ohne eine Unterätzung bei den III-V Schichten ausbilden lassen. Anders ausgedrückt, die Breite an der Oberfläche der Vertiefung ist nur wenig größer oder nicht größer als die Breite an der Unterseite der Vertiefung, also in dem Bodenbereich.

In einer Weiterbildung ist die Ausdehnung der Öffnung der Vertiefung an der Oberfläche in einem Bereich zwischen 0,0 µm und 50 µm oder in einem Bereich zwischen 0,5 µm und 30 µm oder in einem Bereich zwischen 1,0 µm und 15 µm größer als die Ausdehnung der Öffnung der Vertiefung in dem Bodenbereich.

In einer anderen Weiterbildung beträgt die Ausdehnung der Öffnung der Vertiefung an der Oberfläche d.h. an der oberen Kante eine Breite in einem Bereich zwischen 40 µm und 500 µm.

In einer Ausführungsform ist bei der Durchführung des ersten Nassätzschrittes außerhalb der zu erzeugenden Vertiefungen die Oberfläche mit dem ersten Lack vor einem Ätzangriff geschützt.

In einer Weiterbildung weist der erste Lack des ersten Photolithographieprozesses die gleiche chemische Zusammensetzung oder eine andere chemische Zusammensetzung als der zweite Lack des zweiten Photolithographieprozesses auf.

In einer anderen Weiterbildung werden in den Druckprozessen jeweils die gleichen Lacke oder unterschiedliche Lacke als in den Photolithographieprozessen verwendet.

In dem die Seitenflächen der Vertiefung jeweils keinen Steigungswinkel über 90° bzw. keine Unterätzung aufweisen, lassen sich in dem zweiten Photolithographieprozess die Seitenflächen zuverlässig mit einem Lack abdecken, um die III-V Schichten an den Seitenflächen vor einem Ätzangriff bei der Durchführung des zweiten Nassätzschrittes zu schützen.

Es sei angemerkt, dass unter dem Begriff der "steilen Seitenflächen" bei der Vertiefung ausgehend von der Bodenfläche ein Steigungswinkel größer als 45° oder ein Steigungswinkel in einem Bereich zwischen 90° und 45 ° verstanden wird. Anders ausgedrückt, die Seitenflächen der Vertiefung weisen keinen Winkel größer als 90° auf.

In einer Weiterbildung werden bei der Durchführung des ersten Nassätzprozesses in einer ersten Näherung oder Seitenflächen mit einem Steigungswinkel zwischen 90° und 80° oder mit einem Steigungswinkel zwischen 90° und 85° oder exakt senkrechte, d.h. mit einem Steigungswinkel von 90° erzeugt.

In einer anderen Weiterbildung umfassen die Seitenflächen III-V Schichten oder bestehen überwiegend d.h. zu mehr als 50% der Fläche zu mehr als 90% der Fläche oder die Seitenflächen bestehen ausschließlich aus III-V Schichten.

In einer Weiterbildung verbleibt die durch den ersten Ätzprozess bei den Seitenflächen ergebene Topographie bis zu dem Aufbringen des zweiten Lacks während des zweiten Photolithographieprozesses unverändert.

Es versteht sich, dass die Topographie der Seitenflächen auch nach dem Entfernen des Lackes aus dem zweiten Photolithographieprozesses unverändert ist und die Oberfläche die gleiche Topographie nach dem ersten Ätzprozess aufweist.

Auch sei angemerkt, dass bei dem ersten Photolithographieprozess oder bei dem Druckprozess auf der Oberfläche während des ersten Ätzschrittes ausschließlich die Bereiche für die Ausbildung der Durchgangsöffnung frei von Lack sind.

In einer anderen Weiterbildung umfassen die auf der Vorderseite der Germanium-Halbleiterscheibe ausgebildeten III-V Schichten wenigstens eine Solarzelle, mit einem n/p Übergang.

In einer Ausführungsform umfassen die III-V Schichten binäre und / oder ternäre und / oder quaternäre Verbindungen oder die III-V Schichten bestehen aua binären und / oder ternären und / oder quaternären Verbindungen. Insbesondere umfassen oder bestehen die III-V Schichten aus GaAs, InGaAs, (Al)InGaP, AlAs, InP und umfassen Dotierstoffe wie Kohlenstoff und / oder Silizium.

In einer anderen Ausführungsform liegt die Dicke einer einzelnen III-V Schicht zwischen 0,01 µm und 30 µm.

In einer Weiterbildung liegt die Anzahl der aufeinander angeordneten III-V Schichten zwischen 10 und 300 oder zwischen 20 und 150 oder zwischen 30 und 75.

In einer Weiterbildung liegt eine Gesamtdicke der III-V Schichten in einem Bereich zwischen 1 µm und 80 µm oder in einem Bereich zwischen 2 µm und 40 µm oder in einem Bereich zwischen 3 µm und 15 µm.

In einer Ausführungsform sind alle oder zumindest 90 % der III-V Schichten ganzflächig abgeschieden. Vorzugsweise sind die III-V Schichten mittels eines Gasphasenepitaxieverfahrens wie MOVPE abgeschieden.

In einer anderen Ausführungsform ist auf der gesamten Oberfläche die gleiche Anzahl von p/n Übergängen ausgebildet.

In einer anderen Weiterbildung umfassen die auf der Vorderseite der Germanium-Halbleiterscheibe ausgebildeten III-V Schichten wenigstens eine Mehrfachsolarzelle.

Hierbei weist die Mehrfachsolarzelle genau zwei oder genau drei und maximal fünf aufeinandergestapelte Teil-Solarzellen auf, wobei die Teil-Solarzellen elektrisch mittels zwischen den Teil-Solarzellen ausgebildeten Tunneldioden in Serie geschaltet sind.

In einer anderen Weiterbildung ist auf der Vorderseite der Germanium-Halbleiterscheibe mittels Eindiffusion von Dotierstoffen eine n-Schicht ausgebildet. Hierdurch lässt sich in der Germanium-Halbleiterscheibe ebenfalls eine Ge-Teil-Solarzelle ausbilden.

Es versteht sich, dass es sich bei dem Solarzellenstapel um die unterste Teil-Solarzelle handelt, wobei die unterste Teil-Solarzelle bei der Mehrfachsolarzelle die kleineste Bandlücke aufweist und im roten und infraroten Wellenlängenbereich absorbiert.

In einer Weiterbildung ist die Germanium Halbleiterscheibe bzw. das Ge-Halbleitersubstrat p-dotiert.

In einer Ausführungsform ist an der Vorderseite des Germaniumschicht ein n/p Übergang ausgebildet, wobei die n-dotierte Schicht Germaniumschicht mittels des zweiten Nassätzschrittes vollständig entfernt wird, so dass in dem Bodenbereich ausschließlich das p-dotierte Ge-Halbleitersubstrat ausgebildet ist.

In einer anderen Weiterbildung ist zwischen der auf der untersten Teil-Solarzelle und der unmittelbar darauffolgenden weiteren Teil-Solarzelle ein metamorpher Puffer ausgebildet, wobei die weitere Teil-Solarzelle und der metamorpher Puffer aus III-V Schichten bestehen oder zumindest umfassen.

In einer Weiterbildung sind die wenigstens die Seitenflächen bei der Durchführung des zweiten Nassätzschrittes vollständig von dem zweiten Lack bedeckt und hierdurch vollständig vor einem Ätzangriff in dem zweiten Nassätzschritt geschützt.

In einer Ausführungsform ist während des zweiten Nassätzschrittes neben den Seitenflächen der Vertiefung auch die Oberfläche vollständig mit dem zweiten Lack bedeckt und hierdurch vor einem Ätzangriff geschützt.

Anders ausgedrückt bei dem zweiten Photolithographieprozess ist, bis auf die lackfreien Flächen in dem Bodenbereich, die Oberfläche mit dem zweiten Lack vollständig abgedeckt.

In einer anderen Weiterbildung ist bei dem zweiten Photolithographieprozess die Rückseite mit einer Schutzschicht, vorzugsweise mit einem weiteren Lack, bedeckt, um einen Ätzangriff auf der Rückseite der Germanium Halbleiterscheibe zu verhindern.

In einer Weiterbildung wird der erste Photolithographieprozess oder der Druckprozess erst nach der Ausbildung eines ersten Metallkontaktsystems auf der Oberfläche und /oder erst nach einer Ausbildung eines zweiten Metallkontaktsystems auf der Rückseite angewendet.

In einer Ausführungsform ist auf der Oberfläche das erste Metallkontaktsystems als streifenförmiges metallisches Leiterbahnsystem ausgebildet, um bei der Ausbildung einer Einfach oder Mehrfachsolarzelle die Solarzelle elektrisch zu kontaktieren.

In einer anderen Ausführungsform ist auf der Rückseite eine Metallschicht ausgebildet, wobei die Metallschicht in dem Bereich der Durchgangsöffnungen nicht ausgebildet ist. Hierbei bildet die Metallschicht das zweite rückseitige Metallkontaktsystem aus.

In einer Ausführungsform weist die erste Stufe eine Tiefe, d.h. eine Stufenfläche in einem Bereich zwischen 0,05 µm und 20 µm oder in einem Bereich zwischen 0,2 µm und 10 µm oder in einem Bereich zwischen 0,5 µm und 5 µm auf oder in einem Bereich zwischen 0,2 µm und 195 µm oder zwischen 2 µm und 60 µm auf.

In einer Ausführungsform weist die zweite Stufe eine Tiefe, d.h. eine Stufenfläche in einem Bereich zwischen 0,02 µm und 10 µm oder in einem Bereich zwischen 0,1 µm und 5 µm oder in einem Bereich zwischen 0,5 µm und 4 µm auf oder in einem Bereich zwischen 0,2 µm und 20 µm auf.

In einer Ausführungsform werden bei der Durchführung des ersten Nassätzschrittes die III-V Schichten in den lackfreien Bereichen vollständig entfernt und der Bodenbereich wird vorzugsweise ausschließlich durch die Vorderseite der Germanium-Halbleiterscheibe ausgebildet.

In einer anderen Ausführungsform wird bei dem ersten Photolithographieprozess in einem ersten Prozessschritt auf der Oberfläche der Halbleiterscheibe der erste Lack ganzflächig ausgebildet und in einem zweiten Prozessschritt der erste Lack belichtet und entwickelt, um hierbei lackfreie Bereiche herzustellen.

In einer anderen Weiterbildung weist bei dem ersten Ätzschritt die Säure eine Selektivität größer als 10:1 oder größer als 30:1 oder größer als 50:1 auf, d.h. die III-V-Schichten werden von der Säure wenigstens zehnmal oder wenigstens dreißigmal oder wenigstens fünfzigmal schneller als die Germanium Schicht geätzt.

In einer Ausführungsform weist bei der Durchführung des zweiten Nassätzschrittes die Säure gegenüber Germanium eine genauso große Ätzrate oder eine größere Ätzrate als gegenüber den III-V Schichten auf.

In einer Weiterbildung weist die Durchgangsöffnung neben der ersten Stufe auch eine zweite Stufe auf.

In einer anderen Ausführungsform weist die die Vertiefung an der Oberfläche eine maximale Breite in einem Bereich zwischen 40 µm und 500 µm oder in einem Bereich zwischen 2 µm und 100 µm oder in einem Bereich zwischen 4 µm und 40 µm auf.

In einer Weiterbildung weist die Vertiefung an der Oberfläche eine minimale Breite oberhalb von 2 µm oder oberhalb von 4 µm oder oberhalb von 40 µm auf.

In einer Weiterbildung weist das mittels des Lasers erzeugte Durchgangsloch eine kleinere maximale Breite und eine kleinere minimale Breite als die Vertiefung auf.

In einer Ausführungsform wird mit der Durchführung des Laserprozesses in dem Bodenbereich der Vertiefung entlang der Seitenfläche eine umlaufende Stufe ausgebildet wird, wobei das Durchgangsloch in der Bodenfläche eine maximale Breite in einem Bereich zwischen wenigstens 10 µm und maximal 400 µm oder 20 µm bis 200 µm aufweist und eine Durchgangstiefe eine Höhe entsprechend der Dicke der Germaniumschicht aufweist.

Es versteht sich, dass bei dem ersten Photolithographieprozess und auch bei dem zweiten Photolithographieprozess jeweils u.a. ein Belackungsschritt mit einem Lack, ein Aushärtungsschritt, einen Belichtungsschritt mit einer Maske, ein Entwicklungsschritt mit einem Entfernen des Lacks in den belichteten Bereichen - sofern ein Positivlack verwendet wird, umfasst ist.

Wird anstelle des ersten Photolithographieprozesses ein Druckprozess durchgeführt ist es hinreichend, wenn nach dem strukturierten Aufbringen des ersten Lacks ein Aushärtungsschritt stattfindet. Ein Belichtungsschritt und ein Entwicklungsschritt entfallen. Es versteht sich, dass bei einer Anwendung des Druckprozesses das Aufbringen des ersten Lacks der Anwendung eines Positivlacks bei dem ersten Photolithographieprozess gleichkommt.

Anschließend wird jeweils in einem weiteren Verfahrensschritt die jeweilige Nassätzung bzw. Laserprozess und Nassätzung durchgeführt und anschließend mittels eines Veraschungsschritts und einem Reinigungsschritt der Lack vollständig in den nicht belichteten Bereichen entfernt.

In einer Weiterbildung wird die Ausdehnung der Vertiefung bestimmt, indem bei dem ersten Photolithographieprozess in einem ersten Prozessschritt der erste Lack auf der Oberfläche der Halbleiterscheibe ganzflächig ausgebildet und in einem zweiten Prozessschritt der erste Lack mittels einer Maske belichtet und entwickelt wird oder alternativ mittels des ersten Druckprozesses der erste Lack auf der Oberfläche der Halbleiterscheibe strukturiert ausgebildet wird.

In einer Weiterbildung wird bei der Vertiefung und / oder bei dem Durchgangsloch die Öffnung kreisförmig oder als Kreis ausgebildet.

In einer anderen Weiterbildung weisen die auf der Vorderseite ausgebildeten III-V Schichten eine Gesamtdicke zwischen 1 µm und 80 µm oder eine Gesamtdicke zwischen 2 µm und 40 µm oder eine Gesamtdicke zwischen 3 µm und 15 µm auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1a-i: eine Querschnittsprozessabfolge zur Herstellung einer Durchgangsöffnung,
- Figur 2: Querschnitt auf eine alternative Ausführung des in der Fig. 1i abgebildeten Durchgangslochs,
- Figur 3a: Draufsicht auf die Oberfläche der Halbleiterscheibe nach der Ausbildung der Durchgangsöffnung,
- Figur 3b: Draufsicht auf die Rückseite der Halbleiterscheibe nach der Ausbildung der Durchgangsöffnung.

In der dargestellten Ausführungsform weisen aus Gründen der Übersichtlichkeit die dargestellten Strukturen in einem Querschnitt parallel zu einer Rückseite eine kreisförmige Ausbildung aus.

In einer nicht dargestellten Ausführungsform weisen Strukturen in einem Querschnitt parallel zu einer Rückseite keine kreisförmige Ausbildung aus.

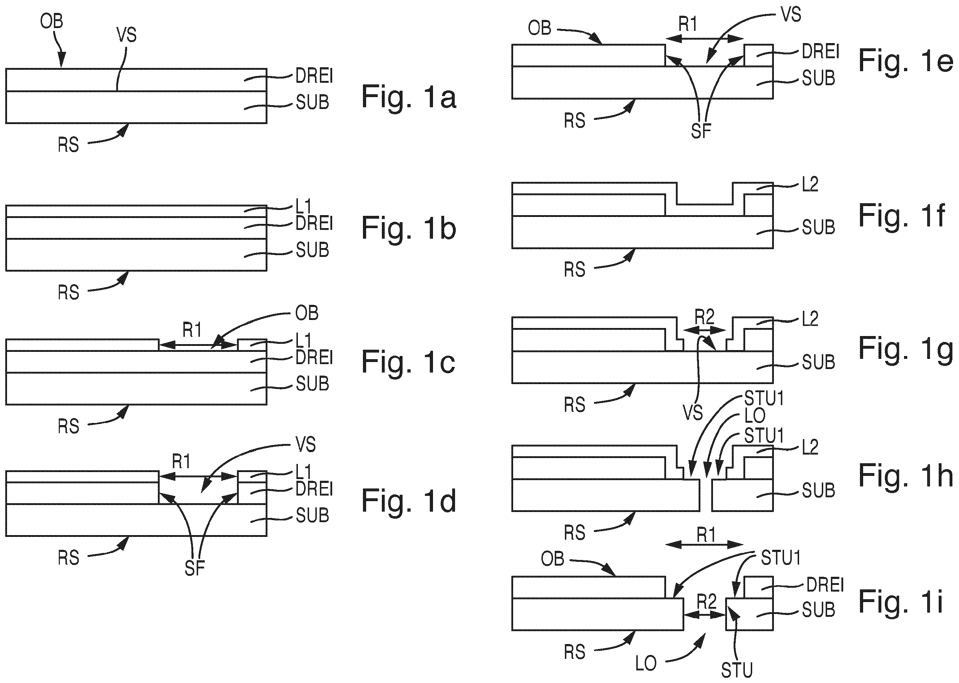

In den Figuren 1a bis 1i werden in einer Querschnittsansicht die einzelnen Verfahrensschritte zur Ausbildung einer Durchgangsöffnung dargestellt. Es versteht sich dabei, dass alle Verfahrensschritte an einer Halbleiterscheibe WF durchgeführt werden und in den Querschnittsabbildungen aus Gründen der Übersichtlichkeit nur die Herstellung einer einzigen Durchgangsöffnung abgebildet ist.

Des Weiteren lassen sich bei einer Ersetzung von einem Photolithographieprozess oder von beiden Photolithographieprozess durch jeweils einen Druckprozess und die Anzahl der Prozessschritte wesentlich verringern. Nachfolgend wird die Herstellung der Durchgangsöffnung unter Verwendung der beiden Photolithographieprozesse erläutert.

In einer nicht dargestellten Ausführungsform werden die beiden Lacke L1 und L2 jeweils mittels Druckprozessen aufgebracht.

In einem ersten Schritt, dargestellt in der Fig. 1a, wird eine Germanium-Halbleiterscheibe SUB mit einer Vorderseite VS und einer Rückseite RS bereitgestellt. Auf der Vorderseite VS ist eine aufliegende Schichtfolge DREI von III-V Schichten ausgebildet.

Die Schichtfolge DREI ist mittels einer Epitaxie, vorzugsweise einem MOVPE Epitaxieverfahren aufgewachsen und umfasst eine Vielzahl von III-V Schichten aus unterschiedlichen Materialien und Dotierungen und weist eine Oberfläche OB auf. Aus Gründen der Übersichtlichkeit sind bei der auflegenden Schichtfolge DREI die einzelnen III-V Schichten nicht abgebildet.

Die Oberfläche OB und die Rückseite RS sind jeweils mit Ausnahme von einem Ritzrahmen planar ausgebildet, insbesondere ist in den vorliegenden Querschnittsabbildungen keine Metallisierung weder an der Oberfläche OB noch auf der Rückseite RS dargestellt.

Es sei angemerkt, dass die Dicke der Leiterbahnen umfassenden Oberfläche OB in einem Bereich von einigen µm liegt. Abgesehen von der Dicke der von der strukturierten Metallisierung ausgebildeten Topographie ist die Oberfläche OB planar ausgebildet. Aus Gründen der Übersichtlichkeit sind die Leiterbahnen an bzw. auf der Oberfläche OB nicht dargestellt.

In einem zweiten Schritt, dargestellt in der Fig. 1b, wird mittels eines ersten Photolithographieprozess die Oberfläche OB ganzflächig mit einem ersten Lack L1 beschichtet. Vorliegend wird hierzu ein Positivlack verwendet.

In einem dritten Schritt, dargestellt in der Fig. 1c, wird nach der Belichtung und Entwicklung des ersten Lackes ist in einem ersten Bereich R1 an der Oberfläche OB der ersten Lack L1 entfernt.

In einem vierten Schritt, dargestellt in der Fig. 1d, sind nach einem ersten Nassätzschritt die III-V Schichten in dem ersten Bereich R1 weggeätzt, sodass der Boden der ovalen Struktur aus der Vorderseite VS gebildet wird.

In einem fünften Schritt, dargestellt in der Fig. 1e, ist der erste Lack L1 vollständig entfernt, so dass auf der Oberfläche OB in dem ersten Bereich R1 eine ovale Struktur ausgebildet ist. Die ovale Struktur weist nahezu senkrecht ausgebildete Seitenflächen SF auf. Die Seitenflächen SF bestehen aus den III-V Schichten.

In einem sechsten Schritt, dargestellt in der Fig. 1f, wird in einem zweiten Photolithographieprozess die Oberfläche OB und die ovale Struktur mit der Bodenfläche und den Seitenflächen SF mit einem zweiten Lack L2 bedeckt.

In einem siebten Schritt, dargestellt in der Fig. 1g, ist in dem Bodenbereich der ovalen Struktur in einem zweiten Bereich R2 der zweite Lack L2 entfernt, wobei der zweite Lack L2 die Oberfläche und die Seitenflächen SF und einen Rand des Bodenbereichs bedeckt. Die Breite des zweiten Bereichs R2 ist geringer als die Breite des ersten Bereichs R1.

In einem achten Schritt, dargestellt in der Fig. 1h, wird mittels eines Laserprozesses innerhalb des zweiten Bereich R2 ein Durchgangsloch LO erzeugt. Hierbei ist die Breite des Durchgangslochs kleiner als die die Breite des zweiten Bereichs R2 und eine erste Stufe STU1 wird ausgebildet.

In der dargestellten Ausführungsform sind der zweite Bereich R2 und das Durchgangsloch LO jeweils kreisförmig ausgebildet. Die Breite des zweiten Bereichs R2 und die Breite des Durchgangslochs LO entsprechen jeweils dem jeweiligen Durchmesser. Die erste Stufe STU1 ist umlaufend ausgebildet.

Nach der Erzeugung des Durchgangsloches LO werden mittels eines zweiten Nassätzschrittes in dem zweiten Bereich R2 das Durchgangsloch und die freiliegenden Bereiche überätzt.

Hierbei wird das Durchgangsloch LO bis auf die Größe R2 erweitert. Des Weiteren lassen sich mittels des zweiten Ätzprozesses eventuelle Ge-Reste oder Ge-Partikel oder Ge-Ablagerungen aus der Anwendung des Laserprozesses entfernen.

Indem der zweite Bereich R2 kleiner als der erste Bereich R1 ist, wird in dem Bereich des Bodens eine zweite umlaufende Stufe STU2 ausgebildet.

In einem neunten Schritt, dargestellt in der Fig. 1i, ist der zweite Lack L2 vollständig entfernt und die Durchgangsöffnung mit der zweiten Stufe STU2 in dem Bodenbereich ist vollständig ausgebildet. Es versteht sich, dass die zweite Stufe STU2 ausschließlich in dem Ge ausgebildet ist.

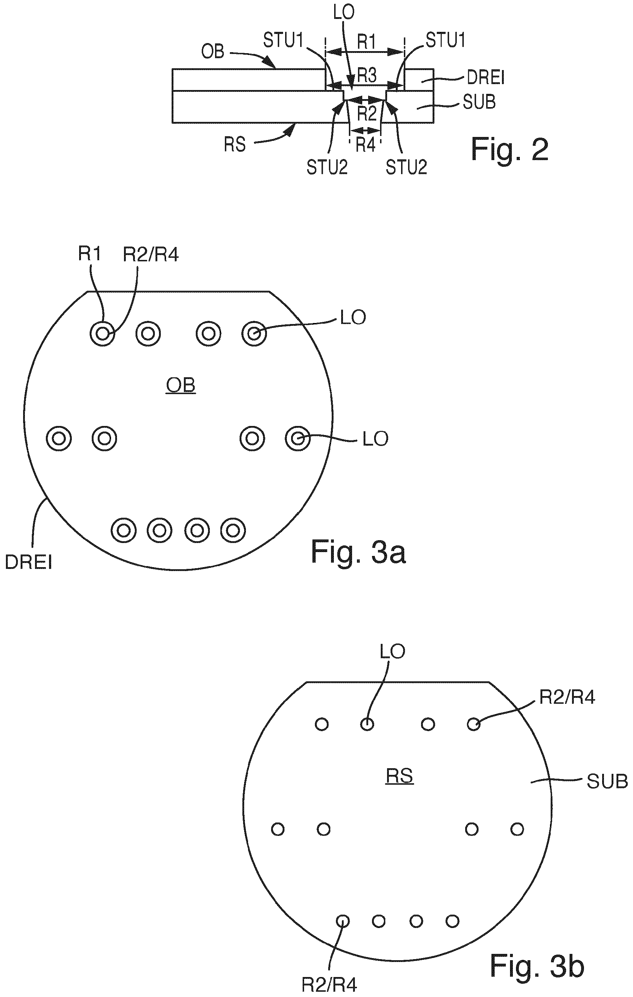

In der Darstellung der Figur 2 ist eine Querschnittsansicht einer alternativen Ausführungsform des in der Fig. 1i abgebildeten Durchgangslochs LO dargestellt.

Ein Unterschied zu der Ausführungsform der Fig. 1i besteht darin, dass das Durchgangsloch LO konisch ausgebildet ist, wobei eine untere Kante einen vierten Durchmesser R4 aufweist und der vierte Durchmesser R4 kleiner ist als der zweite Durchmesser R2. Die untere Kante wird aus der flächig ausgebildeten Rückseite RS und dem Ende des Durchgangsloches gebildet.

Die Abbildung der Figur 3a zeigt eine Draufsicht auf die Oberfläche der Halbleiterscheibe nach der Ausbildung von mehreren Durchgangsöffnungen. Die der Oberfläche OB wird durch eine der III-V -Schichten DREI ausgebildet. Es zeigt sich, dass sich die Durchgangsöffnungen sowohl in dem Randbereich als auch in einem Mittebereich der Germaniumscheibe ausbilden lassen.

In einer nicht darstellten Ausführungsform ist auf der Oberfläche OB ein streifenförmiges ausgebildetes metallisches Leiterbahnsystem ausgebildet.

Die Abbildung der Figur 3b zeigt eine Draufsicht auf die Rückseite RS der Halbleiterscheibe SUB nach der Ausbildung der Durchgangsöffnungen, wie in der Ausführungsform in Zusammenhang mit der Abbildung der Fig. 3a beschrieben. Auf der Rückseite OB ist die Germaniumschicht ganzflächig ausgebildet.

In einer nicht dargestellten Ausführungsform ist auf der Rückseite eine Metallschicht ausgebildet, wobei die Metallschicht in dem Bereich der Durchgangsöffnungen nicht ausgebildet ist.

## Patentansprüche

1. Verfahren zur Herstellung einer Durchgangsöffnung (DOE) bei einer Germanium Halbleiterscheibe (WF) mit aufliegenden III-V Schichten (DREI), wobei
- die Germanium-Halbleiterscheibe (WF) einen Durchmesser von wenigstens 100 mm und eine Dicke oberhalb von 80 µm aufweist,
- die Germanium-Halbleiterscheibe (WF) eine Rückseite (RS) und eine Vorderseite (VS) aufweist und als Substrat (SUB) ausgebildet ist,
- auf der Vorderseite (VS) mehrere III-V Schichten (DREI) ausgebildet sind und ein Teil der III-V Schichten (DREI) eine Oberfläche (OB) der Germanium-Halbleiterscheibe (WF) ausbilden,
- in einem ersten Photolithographieprozess auf der Oberfläche (OB) ein erster Lack (L1) strukturiert wird und bei der Strukturierung erste lackfreie Bereiche (R1) für die Ausbildung der Durchgangsöffnung (DOE) ausgebildet werden,
oder mittels eines ersten Druckprozesses der erste Lack (L1) strukturiert aufgebracht wird, um die ersten lackfreien Bereiche (R1) auszubilden,
**dadurch gekennzeichnet, dass**
- in einem nachfolgenden Prozess die auf der Vorderseite (VS) der Germanium-Halbleiterscheibe (WF) aufliegenden Schichten (DRE) in den ersten lackfreien Bereichen (R1) nasschemisch entfernt werden, um eine ovale lochartige Vertiefung (V1) mit umlaufenden Seitenflächen (SF) und einem Bodenbereich aus der Vorderseite (VS) der Germaniumschicht auszubilden,
- nach dem Entfernen des ersten Lacks (L1) mittels eines zweiten Photolithographieprozesses ein zweiter Lack (L2) auf die Oberseite und in dem Bodenbereich aufgebracht und in dem Bodenbereich der Vertiefung (V1) der Lack (L2) strukturiert wird, um zweite lackfreie Bereiche (R2) in dem Bodenbereich auszubilden, oder
- mittels eines zweiten Druckprozesses der zweite Lack (L2) strukturiert auf die Oberseite und in dem Bodenbereich aufgebracht wird, um die zweiten lackfreien Bereiche (R2) in dem Bodenbereich auszubilden
- in den zweiten lackfreien Bereichen (R2) des Bodenbereichs mittels eines Laserprozesses in der Germaniumschicht ein von dem Bodenbereich der Vertiefung (V1) bis zu der Rückseite (RS) der Germanium-Halbleiterscheibe (WF) reichendes Durchgangsloch (DLO) erzeugt wird,
- in einem nachfolgenden zweiten Nassätzschrittes das Durchgangslochs (DLO) überätzt und ein Teil der Germaniumschicht entfernt wird,
- in einem weiteren Schritt der zweite Lack (L2) vollständig entfernt wird, um die Durchgangsöffnung (DOE) auszubilden, wobei bei der Durchgangsöffnung (DOE) die Breite (R1) der Vertiefung (V1) größer ist als die Breite (R2) des Durchgangslochs (DLO).

2. Verfahren zur Herstellung einer Durchgangsöffnung nach Anspruch 1, **dadurch gekennzeichnet, dass** während des ersten Nassätzschrittes außerhalb der zu erzeugenden Vertiefungen die Oberfläche (OB) mit dem ersten Lack (L1) vor einem Ätzangriff geschützt ist.

3. Verfahren zur Herstellung einer Durchgangsöffnung nach Anspruch 1 oder Anspruch 2, **dadurch gekennzeichnet, dass** während des zweiten Nassätzschrittes die Oberfläche (OB) und die Seitenflächen der Vertiefung mit dem zweiten Lack (L2) vor einem Ätzangriff geschützt sind.

4. Verfahren zur Herstellung einer Durchgangsöffnung nach einem der vorangegangenen Ansprüche, **dadurch gekennzeichnet, dass** in dem Bodenbereich mit der Durchführung des Laserprozesses in dem Bodenbereich der Vertiefung entlang der Seitenfläche (SF) eine umlaufende erste Stufe (STU1) ausgebildet wird, wobei die Durchgangsöffnung in der Bodenfläche eine maximale Breite (R2A) in einem Bereich zwischen wenigstens 10 µm und maximal 400 µm oder 20 µm bis 200 µm aufweist und eine Durchgangstiefe eine Höhe (H1) entsprechend der Dicke der Germanium Halbleiterscheibe (WF) aufweist.

5. Verfahren zur Herstellung einer Durchgangsöffnung nach einem der vorangegangenen Ansprüche, **dadurch gekennzeichnet, dass** die Vertiefung an der Oberfläche eine maximale Breite (R1A) in einem Bereich zwischen 40 µm und 500 µm oder in einem Bereich zwischen 2 µm und 100 µm oder in einem Bereich zwischen 4 µm und 40 µm aufweist.

6. Verfahren zur Herstellung einer Durchgangsöffnung nach einem der vorangegangenen Ansprüche, **dadurch gekennzeichnet, dass** die Vertiefung an der Oberfläche eine minimale Breite (R1B) oberhalb von 2µm oder oberhalb von 4 µm oder oberhalb von 40 µm aufweist.

7. Verfahren zur Herstellung einer Durchgangsöffnung nach einem der vorangegangenen Ansprüche, **dadurch gekennzeichnet, dass** bei der Durchführung des ersten Nassätzschrittes die III-V Schichten in den lackfreien Bereichen vollständig entfernt werden und der Bodenbereich durch die Vorderseite (VS) der Germanium-Halbleiterscheibe ausgebildet wird.

8. Verfahren zur Herstellung einer Durchgangsöffnung nach einem der vorangegangenen Ansprüche, **dadurch gekennzeichnet, dass** die Ausdehnung der Vertiefung bestimmt wird, indem bei dem ersten Photolithographieprozess in einem ersten Prozessschritt der erste Lack (L1) auf der Oberfläche (OB) der Halbleiterscheibe (WF) ganzflächig ausgebildet und in einem zweiten Prozessschritt der erste Lack (L1) mittels einer Maske belichtet und entwickelt wird oder mittels des ersten Druckprozesses der erste Lack (L1) auf der Oberfläche (OB) der Halbleiterscheibe (WF) der strukturiert ausgebildet wird.

9. Verfahren zur Herstellung einer Durchgangsöffnung nach einem der vorangegangenen Ansprüche, **dadurch gekennzeichnet, dass** die Seitenflächen (SF) III-V Schichten (DREI) umfassen oder aus III-V Schichten (DREI) bestehen.

10. Verfahren zur Herstellung einer Durchgangsöffnung nach einem der vorangegangenen Ansprüche, **dadurch gekennzeichnet, dass** bei dem ersten Ätzschritt die Säure eine Selektivität größer als 10:1 aufweist, um die III-V-Schichten (DREI) wesentlich schneller als die Germanium Schicht zu ätzen.

11. Verfahren zur Herstellung einer Durchgangsöffnung nach einem der vorstehenden Ansprüche, **dadurch gekennzeichnet, dass** das mittels des Lasers erzeugte Durchgangsloch eine kleinere maximale Breite (R2A) und eine kleinere minimale Breite (R2B) als die Vertiefung aufweist.

12. Verfahren zur Herstellung einer Durchgangsöffnung nach einem der vorstehenden Ansprüche, **dadurch gekennzeichnet, dass** die Stufenfläche der ersten Stufe (STU1) eine Tiefe in einem Bereich zwischen 0,05 µm und 20 µm oder zwischen 0,5 µm und 5 µm aufweist.

13. Verfahren zur Herstellung einer Durchgangsöffnung nach einem der vorstehenden Ansprüche, **dadurch gekennzeichnet**, bei der Vertiefung und / oder bei dem Durchgangsloch die Öffnung kreisförmig oder als Kreis ausgebildet wird.

14. Verfahren zur Herstellung einer Durchgangsöffnung nach einem der vorstehenden Ansprüche, **dadurch gekennzeichnet, dass** die auf der Vorderseite ausgebildeten III-V Schichten eine Gesamtdicke zwischen 1 µm und 80 µm oder eine Gesamtdicke zwischen 2 µm und 40 µm oder eine Gesamtdicke zwischen 3 µm und 15 µm aufweisen.

15. Verfahren zur Herstellung einer Durchgangsöffnung nach einem der vorstehenden Ansprüche, **dadurch gekennzeichnet, dass** die Durchgangsöffnung neben der ersten Stufe (STU1) auch eine zweite Stufe (STU2) aufweist.

## Claims

1. A method for producing a through-opening (DOE) in a germanium semiconductor wafer (WF) having overlying III-V layers (DREI), wherein
- the germanium semiconductor wafer (WF) has a diameter of at least 100 mm and a thickness greater than 80 µm,
- the germanium semiconductor wafer (WF) has a rear side (RS) and a front side (VS) and is configured as a substrate (SUB),
- multiple III-V layers (DREI) are formed on the front side (VS), and a portion of the III-V layers (DREI) forms a top surface (OB) of the germanium semiconductor wafer (WF),
- in a first photolithography process, a first resist (L1) is patterned on the top surface (OB), and, during the patterning, first resist-free regions (R1) are formed for forming the through-opening (DOE), or the first resist (L1) is applied in a patterned manner by means of a first printing process to form the first resist-free regions (R1),
**characterised in that**
- in a subsequent process, the layers (DRE) overlying the front side (VS) of the germanium semiconductor wafer (WF) are removed by wet-chemical etching in the first resist-free regions (R1) to form an oval, hole-like recess (V1) having circumferential side surfaces (SF) and a base region formed by the front side (VS) of the germanium layer,
- after removal of the first resist (L1), a second resist (L2) is applied to the top side and in the base region by means of a second photolithography process, and the second resist (L2) is patterned in the base region of the recess (V1) to form second resist-free regions (R2) in the base region, or
- by means of a second printing process, the second resist (L2) is applied in a patterned manner to the top side and in the base region to form the second resist-free regions (R2) in the base region,
- in the second resist-free regions (R2) of the base region, a through-hole (DLO) extending from the base region of the recess (V1) to the rear side (RS) of the germanium semiconductor wafer (WF) is produced in the germanium layer by means of a laser process,
- in a subsequent second wet-etching step, the through-hole (DLO) is overetched and a portion of the germanium layer is removed,
- in a further step, the second resist (L2) is completely removed to form the through-opening (DOE), wherein, in the through-opening (DOE), the width (R1) of the recess (V1) is greater than the width (R2) of the through-hole (DLO).

2. The method for producing a through-opening according to claim 1, **characterised in that**, during the first wet-etching step, the top surface (OB) outside the recesses to be produced is protected against an etching attack by the first resist (L1).

3. The method for producing a through-opening according to claim 1 or claim 2, **characterised in that**, during the second wet-etching step, the top surface (OB) and the side surfaces of the recess are protected against an etching attack by the second resist (L2).

4. The method for producing a through-opening according to any one of the preceding claims, **characterised in that**, when the laser process is carried out in the base region of the recess, a circumferential first step (STU1) is formed in the base region along the side surface (SF), wherein the through-opening has, at the base surface, a maximum width (R2A) in a range from at least 10 µm to at most 400 µm or from 20 µm to 200 µm, and a depth (H1) corresponding to the thickness of the germanium semiconductor wafer (WF).

5. The method for producing a through-opening according to any one of the preceding claims, **characterised in that** the recess has, at the top surface, a maximum width (R1A) in a range between 40 µm and 500 µm or in a range between 2 µm and 100 µm or in a range between 4 µm and 40 µm.

6. The method for producing a through-opening according to any one of the preceding claims, **characterised in that** the recess has, at the top surface, a minimum width (R1B) greater than 2 µm or greater than 4 µm or greater than 40 µm.

7. The method for producing a through-opening according to any one of the preceding claims, **characterised in that**, when the first wet-etching step is carried out, the III-V layers in the resist-free regions are completely removed, and the base region is formed by the front side (VS) of the germanium semiconductor wafer.

8. The method for producing a through-opening according to any one of the preceding claims, **characterised in that** the extent of the recess is determined by forming, in a first process step of the first photolithography process, the first resist (L1) over the entire top surface (OB) of the semiconductor wafer (WF) and, in a second process step, exposing the first resist (L1) by means of a mask and developing it, or by forming the first resist (L1) in a patterned manner on the top surface (OB) of the semiconductor wafer (WF) by means of the first printing process.

9. The method for producing a through-opening according to any one of the preceding claims, **characterised in that** the side surfaces (SF) comprise III-V layers (DREI) or consist of III-V layers (DREI).

10. The method for producing a through-opening according to any one of the preceding claims, **characterised in that**, in the first etching step, the acid has a selectivity greater than 10:1 so as to etch the III-V layers (DREI) substantially faster than the germanium layer.

11. The method for producing a through-opening according to any one of the preceding claims, **characterised in that** the through-hole produced by means of the laser has a smaller maximum width (R2A) and a smaller minimum width (R2B) than the recess.

12. The method for producing a through-opening according to any one of the preceding claims, **characterised in that** the step surface of the first step (STU1) has a depth in a range between 0.05 µm and 20 µm or between 0.5 µm and 5 µm.

13. The method for producing a through-opening according to any one of the preceding claims, **characterised in that** the opening of the recess and/or of the through-hole is circular or is formed as a circle.

14. The method for producing a through-opening according to any one of the preceding claims, **characterised in that** the III-V layers formed on the front side have a total thickness between 1 µm and 80 µm or a total thickness between 2 µm and 40 µm or a total thickness between 3 µm and 15 µm.

15. The method for producing a through-opening according to any one of the preceding claims, **characterised in that** the through-opening has a second step (STU2) in addition to the first step (STU1).

## Revendications

1. Procédé de fabrication d'une ouverture traversante (DOE) dans une plaquette semi-conductrice en germanium (WF) comportant des couches III-V sus-jacentes (DREI), dans lequel
- la plaquette semi-conductrice en germanium (WF) présente un diamètre d'au moins 100 mm et une épaisseur supérieure à 80 µm,
- la plaquette semi-conductrice en germanium (WF) présente une face arrière (RS) et une face avant (VS) et est réalisée sous la forme d'un substrat (SUB),
- plusieurs couches III-V (DREI) sont formées sur la face avant (VS), et une partie des couches III-V (DREI) forme une surface supérieure (OB) de la plaquette semi-conductrice en germanium (WF),
- dans un premier procédé de photolithographie, une première résine (L1) est structurée sur la surface supérieure (OB), et, lors de la structuration, de premières zones dépourvues de résine (R1) sont formées pour réaliser l'ouverture traversante (DOE), ou la première résine (L1) est déposée de manière structurée au moyen d'un premier procédé d'impression afin de former les premières zones dépourvues de résine (R1),
**caractérisé en ce que**
- dans un procédé ultérieur, les couches (DRE) sus-jacentes à la face avant (VS) de la plaquette semi-conductrice en germanium (WF) sont éliminées par gravure chimique humide dans les premières zones dépourvues de résine (R1) afin de former un évidement ovale en forme de trou (V1) présentant des surfaces latérales périphériques (SF) et une région de fond formée par la face avant (VS) de la couche de germanium,
- après l'élimination de la première résine (L1), une deuxième résine (L2) est déposée sur la face supérieure et dans la région de fond au moyen d'un deuxième procédé de photolithographie, et la deuxième résine (L2) est structurée dans la région de fond de l'évidement (V1) afin de former de deuxièmes zones dépourvues de résine (R2) dans la région de fond, ou
- au moyen d'un deuxième procédé d'impression, la deuxième résine (L2) est déposée de manière structurée sur la face supérieure et dans la région de fond afin de former les deuxièmes zones dépourvues de résine (R2) dans la région de fond,
- dans les deuxièmes zones dépourvues de résine (R2) de la région de fond, un trou traversant (DLO) s'étendant de la région de fond de l'évidement (V1) jusqu'à la face arrière (RS) de la plaquette semi-conductrice en germanium (WF) est réalisé dans la couche de germanium au moyen d'un procédé laser,
- dans une deuxième étape de gravure humide ultérieure, le trou traversant (DLO) est surgravé et une partie de la couche de germanium est éliminée,
- dans une étape supplémentaire, la deuxième résine (L2) est entièrement éliminée afin de former l'ouverture traversante (DOE), la largeur (R1) de l'évidement (V1) étant supérieure, dans l'ouverture traversante (DOE), à la largeur (R2) du trou traversant (DLO).

2. Procédé de fabrication d'une ouverture traversante selon la revendication 1, **caractérisé en ce que**, pendant la première étape de gravure humide, la surface supérieure (OB), à l'extérieur des évidements à réaliser, est protégée contre une attaque de gravure par la première résine (L1).

3. Procédé de fabrication d'une ouverture traversante selon la revendication 1 ou la revendication 2, **caractérisé en ce que**, pendant la deuxième étape de gravure humide, la surface supérieure (OB) et les surfaces latérales de l'évidement sont protégées contre une attaque de gravure par la deuxième résine (L2).

4. Procédé de fabrication d'une ouverture traversante selon l'une quelconque des revendications précédentes, **caractérisé en ce que**, lors de la mise en œuvre du procédé laser dans la région de fond de l'évidement, un premier gradin périphérique (STU1) est formé dans la région de fond le long de la surface latérale (SF), l'ouverture traversante présentant, au niveau de la surface de fond, une largeur maximale (R2A) comprise entre 10 µm au minimum et 400 µm au maximum, ou entre 20 µm et 200 µm, et une profondeur (H1) correspondant à l'épaisseur de la plaquette semi-conductrice en germanium (WF).

5. Procédé de fabrication d'une ouverture traversante selon l'une quelconque des revendications précédentes, **caractérisé en ce que** l'évidement présente, au niveau de la surface supérieure, une largeur maximale (R1A) comprise entre 40 µm et 500 µm, ou entre 2 µm et 100 µm, ou entre 4 µm et 40 µm.

6. Procédé de fabrication d'une ouverture traversante selon l'une quelconque des revendications précédentes, **caractérisé en ce que** l'évidement présente, au niveau de la surface supérieure, une largeur minimale (R1B) supérieure à 2 µm, ou supérieure à 4 µm, ou supérieure à 40 µm.

7. Procédé de fabrication d'une ouverture traversante selon l'une quelconque des revendications précédentes, **caractérisé en ce que**, lors de la mise en œuvre de la première étape de gravure humide, les couches III-V présentes dans les zones dépourvues de résine sont entièrement éliminées et la région de fond est formée par la face avant (VS) de la plaquette semi-conductrice en germanium.

8. Procédé de fabrication d'une ouverture traversante selon l'une quelconque des revendications précédentes, **caractérisé en ce que** l'étendue de l'évidement est déterminée en formant, dans une première étape du premier procédé de photolithographie, la première résine (L1) sur la totalité de la surface supérieure (OB) de la plaquette semi-conductrice (WF), puis, dans une deuxième étape, en exposant la première résine (L1) au moyen d'un masque et en la développant, ou en formant la première résine (L1) de manière structurée sur la surface supérieure (OB) de la plaquette semi-conductrice (WF) au moyen du premier procédé d'impression.

9. Procédé de fabrication d'une ouverture traversante selon l'une quelconque des revendications précédentes, **caractérisé en ce que** les surfaces latérales (SF) comprennent des couches III-V (DREI) ou sont constituées de couches III-V (DREI).

10. Procédé de fabrication d'une ouverture traversante selon l'une quelconque des revendications précédentes, **caractérisé en ce que**, lors de la première étape de gravure, l'acide présente une sélectivité supérieure à 10:1 afin de graver les couches III-V (DREI) sensiblement plus rapidement que la couche de germanium.

11. Procédé de fabrication d'une ouverture traversante selon l'une quelconque des revendications précédentes, **caractérisé en ce que** le trou traversant réalisé au moyen du laser présente une largeur maximale (R2A) et une largeur minimale (R2B) inférieures à celles de l'évidement.

12. Procédé de fabrication d'une ouverture traversante selon l'une quelconque des revendications précédentes, **caractérisé en ce que** la surface de gradin du premier gradin (STU1) présente une profondeur comprise entre 0,05 µm et 20 µm, ou entre 0,5 µm et 5 µm.

13. Procédé de fabrication d'une ouverture traversante selon l'une quelconque des revendications précédentes, **caractérisé en ce que** l'ouverture de l'évidement et/ou du trou traversant est circulaire ou réalisée sous la forme d'un cercle.

14. Procédé de fabrication d'une ouverture traversante selon l'une quelconque des revendications précédentes, **caractérisé en ce que** les couches III-V formées sur la face avant présentent une épaisseur totale comprise entre 1 µm et 80 µm, ou une épaisseur totale comprise entre 2 µm et 40 µm, ou une épaisseur totale comprise entre 3 µm et 15 µm.

15. Procédé de fabrication d'une ouverture traversante selon l'une quelconque des revendications précédentes, **caractérisé en ce que** l'ouverture traversante présente, outre le premier gradin (STU1), un deuxième gradin (STU2).
